# EUROPEAN PATENT APPLICATION

(11) **EP 3 355 456 A1**
(43) Date of publication of application: **01.08.2018**
(21) Application number: 17153607.1
(22) Date of filing: 27.01.2017
(51) Int. Cl.: H02M 1/32, H02H 7/122, H02H 7/16, H02H 9/04, H02M 7/483

(54) **A PROTECTION ARRANGEMENT FOR AN MMC-HVDC SUB-MODULE**

(71) Applicant: General Electric Technology GmbH, 5400 Baden (CH)
(72) Inventor: DAVIDSON, Colin Charnock, Stafford, Staffordshire ST17 4PS (GB)
(74) Representative: Fischer, Michael Maria

(57) **Abstract**

In the field of voltage source converters for high voltage direct current (HVDC) power transmission there is provided a protection arrangement (10; 100; 200; 300; 400; 600; 700) for a switching device (22; 122). The protection arrangement (10; 100; 200; 300; 400; 600; 700) comprises a thyristor (12) that has main current-carrying terminals which in use are connected in reverse parallel with a switching device (22; 122) to be protected, whereby during normal operation of the switching device (22; 122) a reverse voltage is applied to the thyristor (12). The protection arrangement (10; 100; 200; 300; 400; 600; 700) also includes a trigger circuit (38) that is operatively connected with a gate control terminal (40) of the thyristor (12). The trigger circuit (38) is configured to apply a voltage to the gate control terminal (40) of the thyristor (12) when the reverse voltage applied to the thyristor (12) reaches a safety threshold voltage (V₂) whereby the thyristor (12) fails and presents an irreversible short-circuit across the main current-carrying terminals of the switching device (22; 122).

## Description

This invention relates to a protection arrangement for a switching device, and in particular for a switching device in the form of a switching module for a voltage source converter.

In high voltage direct current (HVDC) power transmission, alternating current (AC) electrical power is converted to high voltage direct current (DC) power for transmission via overhead lines and/or undersea cables. This conversion reduces the cost per kilometre of the lines and/or cables, and is therefore cost-effective when power needs to be transmitted over a long distance. Once the transmitted electrical power reaches its target destination, the high voltage DC electrical power is converted back to AC electrical power before being distributed to local networks.

The conversion of AC power to DC power is also commonly utilized in power transmission networks in circumstances where it is necessary to interconnect two AC networks operating at different frequencies.

HVDC power converters are required at each interface between AC and DC networks to effect the required conversion between AC power and DC power, with one type of such a power converter being a voltage source converter which comprises a plurality of series-connected switching devices in the form of switching modules that are operable to provide a stepped variable voltage source.

According to a first aspect of the invention there is provided a protection arrangement for a switching device, comprising:
a thyristor having main current-carrying terminals which in use are connected in reverse parallel with a switching device to be protected, whereby during normal operation of the switching device a reverse voltage is applied to the thyristor; and
a trigger circuit operatively connected with a gate control terminal of the thyristor, the trigger circuit being configured to apply a voltage to the gate control terminal of the thyristor when the reverse voltage applied to the thyristor reaches a safety threshold voltage whereby the thyristor fails and presents an irreversible short-circuit across the main current-carrying terminals of the switching device.

Ordinarily circuit designers go to some lengths to avoid destroying thyristors but deliberately provoking a failure of the thyristor in the foregoing manner provides greater certainty as to the actual voltage at which the thyristor will fail, e.g. compared with simply exposing the thyristor to a damaging voltage across its main current-carrying terminals, and so reduces the margin needed to be included between the normal operating voltage across the switching device, i.e. the normal reverse voltage applied to the thyristor, and the voltage at which the thyristor fails.

Moreover, such a reduction in the safety margin needed is achieved without adversely impacting on the likelihood of the thyristor failing inadvertently, e.g. due to cosmic rays.

In a preferred embodiment of the invention:
the switching device takes the form of a switching module for a voltage source converter, such a switching module including a plurality of switching elements connected in parallel with a primary energy storage device and being selectively operable to provide a voltage source;
the trigger circuit includes an auxiliary energy storage device; and
the trigger circuit is configured in use to selectively connect the auxiliary energy storage device in parallel with the primary energy storage device during normal operation of the switching device, and to selectively connect the auxiliary energy storage device in series with the primary energy storage device and the gate control terminal of the thyristor when the reverse voltage applied to the thyristor reaches the safety threshold voltage.

Connecting the auxiliary energy storage device in parallel with the primary energy storage device allows the voltage across the auxiliary energy storage device to essentially track the voltage across the primary energy storage device during normal operation of the switching device, and so have a negligible impact on such normal operation of the switching device.

Meanwhile, connecting the auxiliary energy storage device in series with the primary energy storage device and the gate control terminal of the thyristor, when the reverse voltage applied to the thyristor exceeds the threshold voltage, allows the voltage across the primary energy storage device to sum with the voltage across the auxiliary energy storage device and thereby provide a suitable source of the voltage to be applied to the gate control terminal of the thyristor to cause its deliberate failure.

Optionally the trigger circuit includes a first passive current check element selectively operable in respective current blocking and current conducting states, the first passive current check element in use being electrically connected in series between a positive terminal of the primary energy storage device and a negative terminal of the auxiliary energy storage device.

Such an arrangement desirably permits the selective connection of the auxiliary energy storage device in series with the primary energy storage device.

The first passive current check element may operate in its current blocking state when the voltage across it is less than a first trigger voltage, and may operate in its current conducting state when the voltage across it is greater than or equal to the first trigger voltage.

The inclusion of a first passive current check element having such functionality advantageously allows the voltage at which the check element switches to operating in its current conducting state to be defined relatively accurately.

Preferably the first trigger voltage is selected to equal the safety threshold voltage.

Selecting the first trigger voltage in such a manner permits the safety threshold voltage to be accurately controlled.

According to another preferred embodiment of the invention the trigger circuit includes a second passive current check element selectively operable in respective current blocking and current conducting states, the second passive current check element in use being electrically connected in series between a positive terminal of the auxiliary energy storage device and the gate control terminal of the thyristor.

Such an arrangement desirably permits the selective connection of the auxiliary energy storage device in series with the gate control terminal of the thyristor.

Optionally the second passive current check element operates in its current blocking state when the voltage across it is less than a second trigger voltage, and operates in its current conducting state when the voltage across it is greater than or equal to the second trigger voltage.

The second trigger voltage may be less than or equal to the first trigger voltage.

The foregoing features help to ensure that the positive terminal of the auxiliary energy storage device is connected in series with the gate control terminal of the thyristor as soon as the auxiliary energy storage device is connected in series with the primary energy storage device.

Preferably at least one passive current check element is one of:
- a breakover diode; and
- a spark gap.

Components of this type have desirable operating characteristics as well as a very small footprint such that they are suitable for mounting on, e.g. a printed circuit board.

In a further preferred embodiment of the invention the auxiliary energy storage device is in use connected in parallel with the primary energy storage device via at least one series-connected resistive element.

Connecting the auxiliary energy storage device in such a manner helps to control the rate at which it stores energy, and hence permits a tuning of the energy storage rate, e.g. so that the voltage across the auxiliary energy storage device can track relatively accurately the voltage across the primary energy storage device.

At the same time, the inclusion of one or more series-connected resistive elements effectively de-couples the auxiliary energy storage device from the primary energy storage device in terms of changes in the voltage across the primary energy storage device occurring on timescales, e.g. of a few microseconds.

According to a second aspect of the invention there is provided a switching module for a voltage source converter including at least one protection arrangement as described hereinabove.

The switching module of the invention shares the corresponding advantages of the protection arrangement of the invention.

There now follows a brief description of preferred embodiments of the invention, by way of non-limiting example, with reference being made to the accompanying figures in which:
Figure 1 shows a protection arrangement according to a first embodiment of the invention;
Figure 2 shows a protection arrangement according to a second embodiment of the invention;
Figure 3 shows a protection arrangement according to a third embodiment of the invention;
Figures 4(a) to 4(d) illustrate various stages in the operation of the protection arrangement shown in Figure 1;
Figure 5 shows a protection arrangement according to a fourth embodiment of the invention;
Figure 6 shows a protection arrangement according to a fifth embodiment of the invention;
Figures 7(a) and 7(b) illustrate different modes of operation of the protection arrangement shown in Figure 5;
Figure 8 shows an alternative protection arrangement, not forming a part of the invention, based on the fifth embodiment of the invention; and
Figure 9 shows a protection arrangement according to a sixth embodiment of the invention.

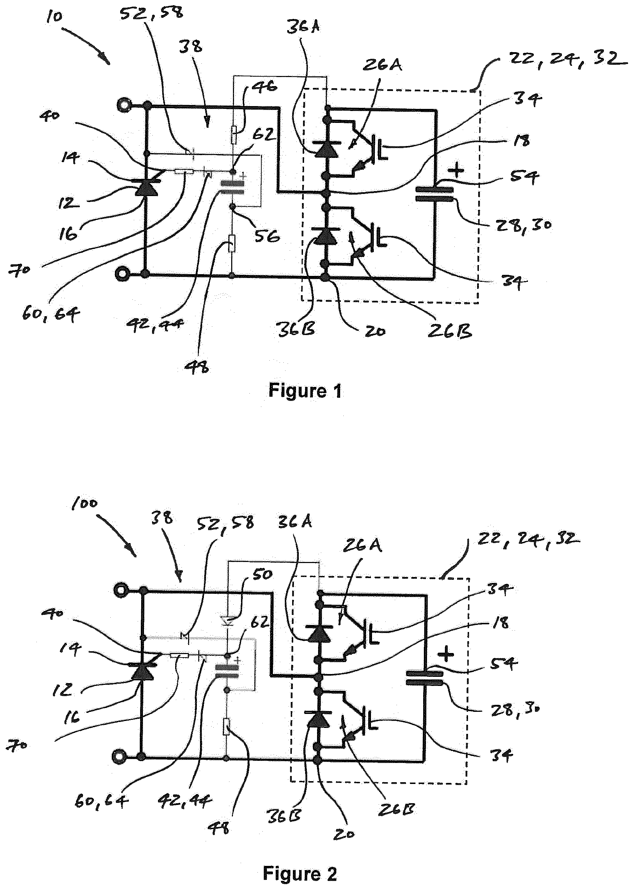

A protection arrangement according to a first embodiment of the invention is designated generally by reference numeral 10, as shown in Figure 1.

The first protection arrangement 10 includes a thyristor 12 which has main current-carrying terminals, i.e. a cathode terminal 14 and an anode terminal 16, which, in use, are connected in reverse parallel with a switching device 22 to be protected.

In the embodiment shown the switching device 22 takes the form of a switching module 24 for a voltage source converter (not shown). The switching module 24 includes a plurality of switching elements 26A, 26B that are connected in parallel with a primary energy storage device 28 in the form of a primary capacitor 30 (although other forms of energy storage device are also possible), and the module 24 is selectively operable to provide a voltage source.

More particularly, in the embodiment shown the switching module 24 is a half-bridge module 32 which includes first and second series-connected switching elements 26A, 26B in the form of respective insulated-gate bipolar transistors (IGBTs) 34 (each of which is connected in anti-parallel with a corresponding first or second diode 36A, 36B) that are connected in parallel with the primary capacitor 30. Other types of switching element may also be used. In any event the half-bridge module 32 is capable of providing zero or positive voltage and conducting current in two directions.

The thyristor 12 is in use connected in reverse parallel with the switching device 22, i.e. the half-bridge module 32, by connecting the cathode terminal 14 of the thyristor 12 to a first main current-carrying terminal 18 of the switching device 22 and the anode terminal 16 of the thyristor 12 to a second main current-carrying terminal 20 of the switching device 22, such that during normal operation of the switching device 22 a reverse voltage is applied to the thyristor 12.

The first protection arrangement 10 also includes a trigger circuit 38 which is operatively connected with a gate control terminal 40 of the thyristor 12.

The trigger circuit 38 is configured to apply a voltage to the gate control terminal 40 of the thyristor 12 when the reverse voltage applied to the thyristor 12, i.e. the voltage across the switching module 24, reaches a safety threshold voltage V₂.

More particularly, the trigger circuit 38 includes an auxiliary energy storage device 42 in the form of an auxiliary capacitor 44 (although other forms of energy storage device may be used) which is, in use, connected in parallel with the primary energy storage device 28, i.e. the primary capacitor 30, via first and second series-connected resistive elements 46, 48.

Each of the first and second resistive elements 46, 48 is a resistor, although in a second protection arrangement 100 according to a second embodiment of the invention (as shown schematically in Figure 2) the first resistive element 46 may be replaced by a diode 50.

In the embodiment shown in Figure 1 the auxiliary capacitor 44 has a capacitance of approximately 1nF, while the first and second resistors have a total resistance of approximately 100kΩ. This establishes a time constant, i.e. capacitance x resistance, for the parallel-connected auxiliary capacitor 44 of approximately 100µs which is relatively short compared to the fundamental frequency cycle of the switching module 24, which typically is about 50Hz or 60Hz. Other capacitance and total resistance values may also be used however.

The trigger circuit 38 also includes a first passive current check element 52 which is, in use, electrically connected in series between a positive terminal 54 of the primary capacitor 30, e.g. via the first terminal 18 of the switching module 24 (which is itself connected in series with the positive terminal 54 of the primary capacitor 30 via the first anti-parallel diode 36A of the first switching element 26A), and a negative terminal 56 of the auxiliary capacitor 44.

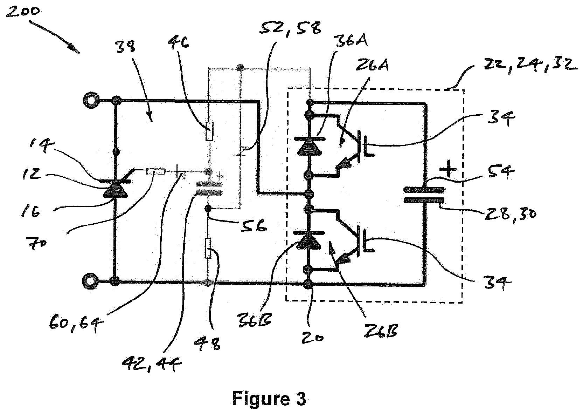

In a third protection arrangement 200 according to a third embodiment of the invention the first passive current check element 52 may instead be electrically connected directly with the positive terminal 54 of the primary capacitor 30, as shown schematically in Figure 3.

In each embodiment the first passive current check element 52 takes the form of a first breakover diode 58 which is selectively operable in respective current blocking and current conducting states, and more particularly operates in its current blocking state when the voltage across it is less than a first trigger voltage, and operates in its current conducting state when the voltage across it is greater than or equal to the first trigger voltage. Other types of passive current check elements may be used, however, including for example a spark gap such as a gas discharge tube.

The first trigger voltage is selected to equal the safety threshold voltage V₂, which by way of example may be 3kV for a switching module 24 with an operational rating of approximately 3.3kV.

The trigger circuit 38 also includes a second passive current check element 60 which is, in use, electrically connected in series between a positive terminal 62 of the auxiliary capacitor 44 and the gate control terminal 40 of the thyristor 12.

The second passive current check element 60 takes the form of a second breakover diode 64 which is similarly selectively operable in respective current blocking and current conducting states, and more particularly operates in its current blocking state when the voltage across it is less than a second trigger voltage, and operates in its current conducting state when the voltage across it is greater than or equal to the second trigger voltage.

The second trigger voltage may be approximately the same as, or slightly less than the first trigger voltage V₂, and in the example embodiment shown preferably is approximately 2.9kV.

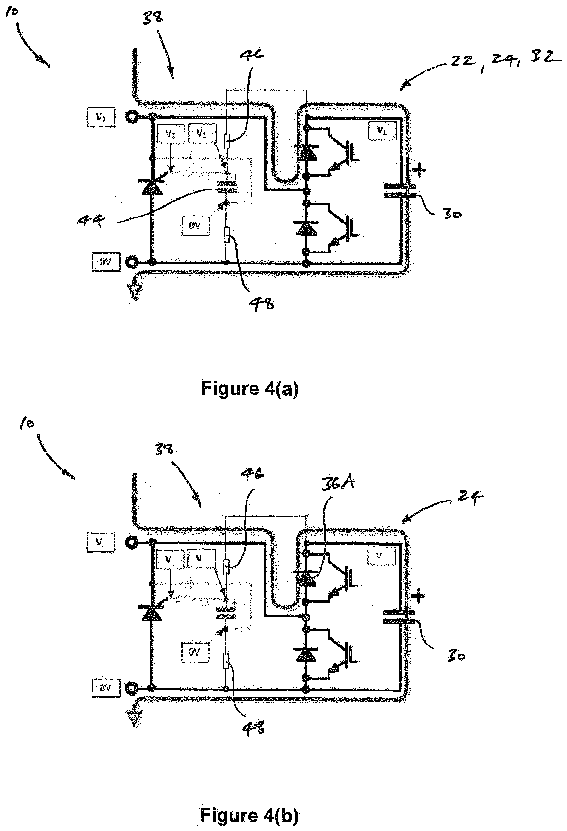

In use, during normal operation of the switching module 24, the trigger circuit 38 is configured to connect the auxiliary capacitor 44 in parallel with the primary capacitor 30, i.e. via the first and second resistive elements 46, 48 as shown in Figure 4(a).

During such normal operation of the switching module 24 the auxiliary capacitor 44 is charged in parallel with the primary capacitor 30 and, because of the relatively short time constant of approximately 100µs, the voltage across the auxiliary capacitor 44 tracks with minimal delay the voltage V₁ across the primary capacitor 30 such that, to a good approximation, the voltage across the auxiliary capacitor 44 is equal to the voltage V₁ across the primary capacitor 30.

In the event of a fault within the switching module 24, the primary capacitor 30 starts to charge to a higher-than-normal voltage V₂ (via the first, uppermost anti-parallel diode 36A shown in Figure 1), as shown in Figure 4(b).

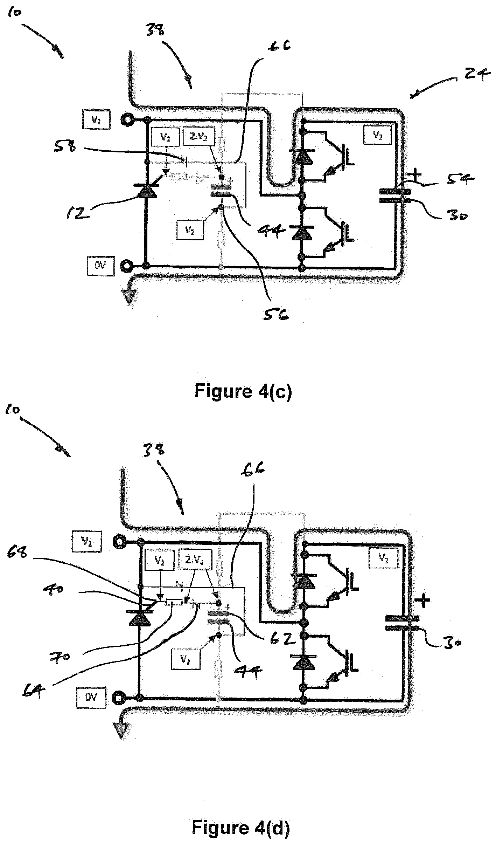

The reverse voltage applied to the thyristor 12 is equal to the higher-than-normal voltage V₂ across the primary capacitor 30 and the auxiliary capacitor 44 is similarly charged with the primary capacitor 30 to the higher-than-normal voltage V₂. This higher-than-normal voltage V₂ equals the safety threshold voltage and the first trigger voltage of the first breakover diode 58, and so the first breakover diode 58 switches to operating in its current conducting state which establishes a first series conducting path 66 between the positive terminal 54 of the primary capacitor 30 and the negative terminal 56 of the auxiliary capacitor 44, as shown in Figure 4(c). In this regard, in relation to the associated timescale over which the first breakover diode 58 switches to operating in its current conducting state, i.e. a few microseconds, the first and second resistive elements 46, 48 play no part in the process.

Once the first series conduction path 66 is established the auxiliary capacitor 44 is effectively connected in series with the primary capacitor 30 and the voltage level at the positive terminal 62 of the auxiliary capacitor 44 rises to 2.V₂, e.g. 6kV.

This gives rise to a voltage across the second breakover diode 64 of V₂, i.e. 2.V₂ - V₂, which at approximately 3kV is greater than the second trigger voltage, e.g. 2.9kV, of the second breakover diode 64 and so the second breakover diode 64 immediately switches to operating in its current conducting state which, in turn, establishes a second series conducting path 68 between the positive terminal 62 of the auxiliary capacitor 44 and the gate control terminal 40 of the thyristor 12, as shown in Figure 4(d).

In the foregoing manner the trigger circuit 38 is selectively configured to connect the auxiliary capacitor 44 in series with each of the primary capacitor 30 and the gate control terminal 40 of the thyristor 12 when the voltage across the primary capacitor 30, and hence the reverse voltage applied to the thyristor 12, reaches the safety threshold voltage V₂.

Such a series connection of the auxiliary capacitor 44, the primary capacitor 30 and the gate control terminal 40 of the thyristor 12 applies a voltage, optionally via a current limiting resistor 70 of around 1kΩ, to the gate control terminal 40 of the thyristor 12. This, in combination with the large reverse voltage V₂ applied to the thyristor 12, causes the thyristor 12 to fail and thereby present an irreversible short-circuit across the first and second terminals 18, 20 of the switching module 24. Such a short-circuit bypasses the switching module 24 and prevents any further increase in the voltage across the primary capacitor 30, and so protects the switching elements 26A, 26B within the switching module 24, in particular, from being damaged any further.

The second and third protection arrangements 100; 200 shown in Figures 2 and 3 are very similar to the first protection arrangement 10 and like features share the same reference numerals. The second and third protection arrangements 100; 200 function in a similar manner as the first protection arrangement 10.

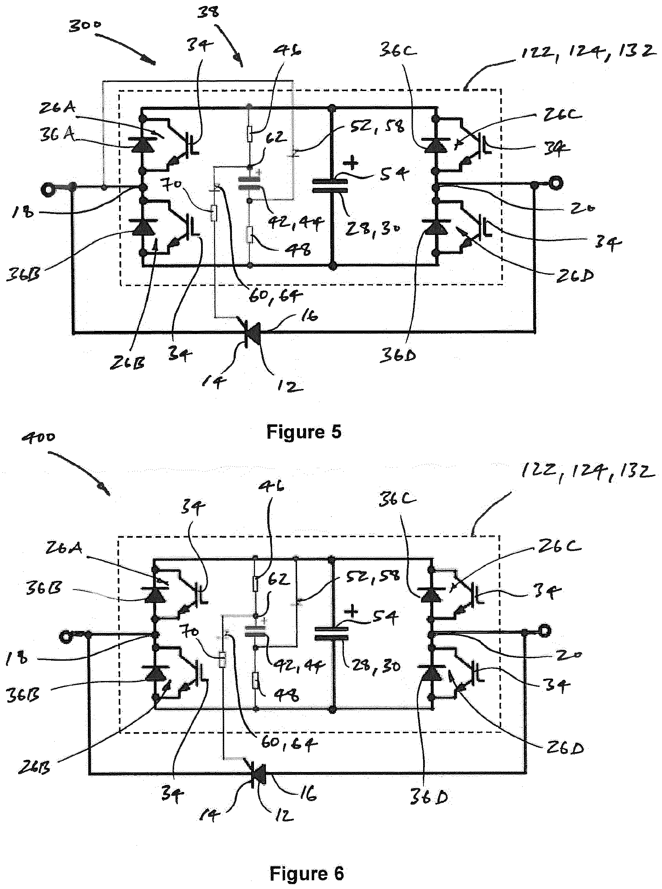

A protection arrangement according to a fourth embodiment of the invention is designated generally by reference numeral 300, as shown in Figure 5.

The fourth protection arrangement 300 is similar to each of the first, second and third protection arrangements 10; 100; 200 and like features share the same reference numerals. The fourth protection arrangement 300 again includes a thyristor 12 which is, in use, connected in reverse parallel with a second switching device 122 to be protected.

In the embodiment shown the second switching device 122 takes the form of a second switching module 124 for a voltage source converter (not shown). More particularly the second switching module 124 is a full bridge module 132 which includes a first pair of first and second series-connected switching elements 26A, 26B and a second pair of third and fourth series-connected switching elements 26C, 26D, both of which series-connected pairs are connected in parallel with a primary capacitor 30. Each switching element 26A, 26B, 26C, 26D again takes the form of a respective IGBT 34 connected in anti-parallel with a corresponding first, second, third, or fourth diode 36A, 36B, 36C, 36D. In the foregoing manner the full bridge module 132 is capable of providing zero, positive or negative voltage and conducting current in two directions.

The thyristor 12 is in use connected in reverse parallel with the second switching device 122, i.e. the full bridge module 132, by again connecting the cathode terminal 14 of the thyristor 12 to a first main current-carrying terminal 18 of the second switching device 122 and the anode terminal 16 of the thyristor 12 to a second main current-carrying terminal 20 of the second switching device 122, such that during normal operation of the second switching device 122 a reverse voltage is again applied to the thyristor 12.

The fourth protection arrangement 300 again includes a trigger circuit 38 which is operatively connected with the gate control terminal 40 of the thyristor 12, and which is configured to apply a voltage to the gate control terminal 40 of the thyristor 12 when the reverse voltage applied to the thyristor 12, i.e. the voltage across the second switching module 124, reaches a safety threshold voltage V₂.

The first passive current check element 52 of the trigger circuit 38 is again, in use, electrically connected in series with the positive terminal 54 of the primary capacitor 30 via the first main current-carrying terminal 18 and the first anti-parallel diode 36A of the first switching element 26A, although the first passive current check element 52 may again instead be electrically connected directly with the positive terminal 54 of the primary capacitor 30, e.g. as in a fifth protection arrangement 400 according to a further embodiment of the invention shown schematically in Figure 6.

In use, during normal operation of the second switching module 124, the auxiliary capacitor 44 of the trigger circuit is again connected in parallel with the primary capacitor 30, i.e. via the first and second resistive elements 46, 48, and so is charged in parallel with the primary capacitor 30 such that the voltage across the auxiliary capacitor 44 is essentially equal to the voltage V₁ across the primary capacitor 30.

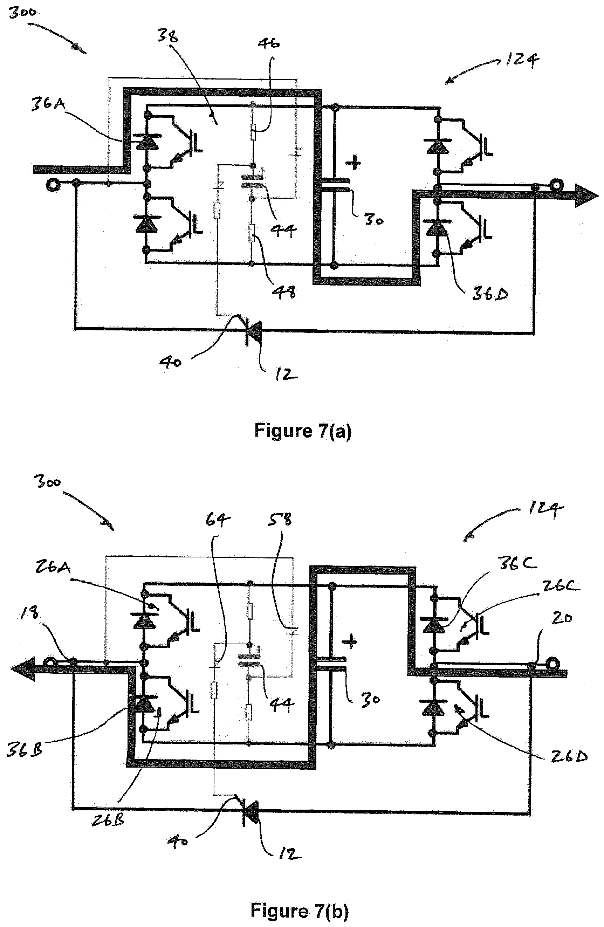

Given the full bridge nature of the second switching module 124, such charging of the primary and auxiliary capacitors 30, 44 takes place in a first mode, as shown in Figure 7(a), as well as a second mode, as shown in Figure 7(b).

In the first mode current flows through the primary capacitor 30 via the first and fourth anti-parallel diodes 36A, 36D and a reverse voltage is applied to the thyristor 12. The trigger circuit 38 functions in essentially the same manner as described above in connection with the first protection arrangement 10, i.e. the trigger circuit 38 acts to selectively connect each of the auxiliary capacitor 44 and the primary capacitor 30 in series with the gate control terminal 40 of the thyristor 12 when the voltage across the primary capacitor 30 reaches the safety threshold voltage V₂ which, in turn, applies a voltage to the gate control terminal 40 of the thyristor 12 that causes the thyristor 12 to fail because the thyristor 12 has a reverse voltage applied to it.

In the second mode current flows through the primary capacitor 30 via the third and second anti-parallel diodes 36C, 36B, as shown in Figure 7(b), and a forward voltage is applied the thyristor 12.

During this mode, if the voltage across the primary capacitor 30 increases to the safety threshold voltage, i.e. V₂, the second breakover diode 64 would instead first of all switch to operating in its current conducting state, and then subsequently the first breakover diode 58 would switch to operating in its current conducting state, whereby a series connection between the primary and auxiliary capacitors 30, 44 and the gate control terminal 40 of the thyristor 12 is again established to apply a voltage to the gate control terminal 40.

However, because in this second mode the thyristor 12 is forward-biased it is triggered into conduction, i.e. it is simply turned on, rather than being destroyed. Such turn on of the thyristor 12 nevertheless creates a temporary short-circuit across the first and second terminals 18, 20 of the second switching module 124 which momentarily prevents any further increase in voltage across the primary capacitor 30, and so provides a useful degree of protection to the switching elements 26A, 26B, 26C, 26D within the second switching module 124.

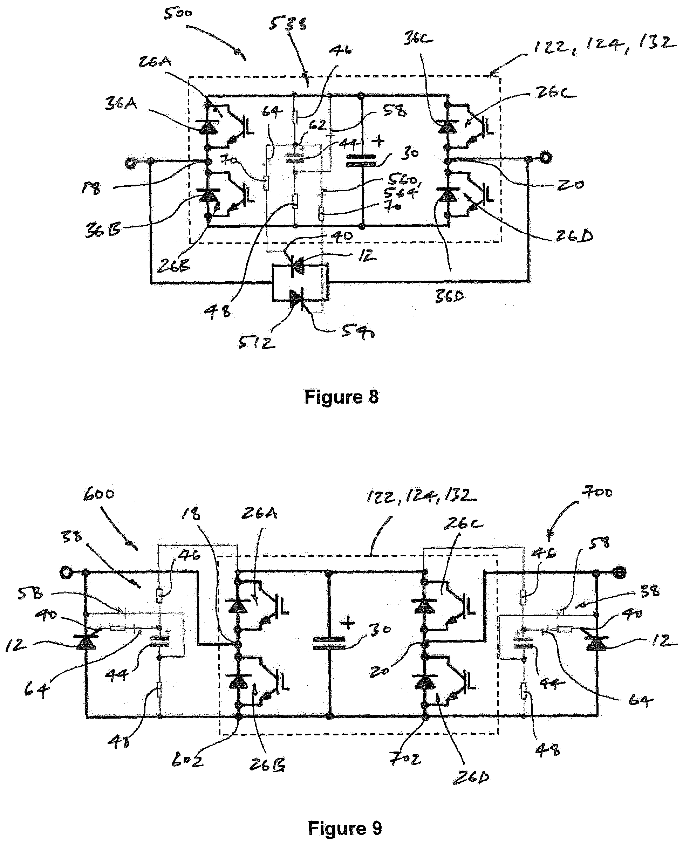

A further protection arrangement 500, not forming a part of the invention but which nevertheless is similar to each of the fourth and fifth protection arrangements 300; 400, is shown schematically in Figure 8.

The further protection arrangement 500 similarly includes a first thyristor 12 which is, in use, connected in reverse parallel with a second switching device 122 in the form of a full bridge module 132. The further protection arrangement 500 does, however, additionally include a second thyristor 512 that is connected in inverse-parallel with the first thyristor 12.

Also, the trigger circuit 538 of the further protection arrangement 500 additionally includes a third passive current check element 560, in the form of a third breakover diode 564, which is in use electrically connected in series between the positive terminal 62 of the auxiliary capacitor 44 and the gate control terminal 540 of the second thyristor 512.

The third breakover diode 564 is similarly selectively operable in respective current blocking and current conducting states, and more particularly operates in its current blocking state when the voltage across it is less than the second trigger voltage, and operates in its current conducting state when the voltage across it is greater than or equal to the second trigger voltage.

In use, given the full bridge nature of the second switching module 124, charging of the primary and auxiliary capacitors 30, 44 takes place in the same first and second modes as described herein above in relation to the fourth protection arrangement 300.

In the first mode, i.e. when current is flowing through the primary capacitor 30 via the first and fourth anti-parallel diodes 36A, 36D of the second switching module 124, the second thyristor 512 is forward-biased, and so when the voltage across the primary capacitor 30 reaches the safety threshold voltage V₂ and the trigger circuit 538 acts to selectively connect each of the auxiliary capacitor 44 and the primary capacitor 30 in series with both the gate control terminal 40 of the first thyristor 12 and the gate control terminal 540 of the second thyristor, the second thyristor 512 is simply triggered into conduction and a temporary short-circuit is created across the first and second terminals 18, 20 of the second switching module 124 which momentarily prevents any further increase in voltage across the primary capacitor 30, and so provides a useful degree of protection to the switching elements 26A, 26B, 26C, 26D within the second switching module 124.

In the second mode, i.e. when current is flowing through the primary capacitor 30 via the third and second anti-parallel diodes 36C, 36B of the second switching module 124, the first thyristor 12 is forward-biased, and so when the voltage across the primary capacitor 30 reaches the safety threshold voltage V₂ and the trigger circuit 538 acts to selectively connect each of the auxiliary capacitor 44 and the primary capacitor 30 in series with both the gate control terminal 40 of the first thyristor 12 and the gate control terminal 540 of the second thyristor, the first thyristor 12 is simply triggered into conduction and a temporary short-circuit is created across the first and second terminals 18, 20 of the second switching module 124 which momentarily prevents any further increase in voltage across the primary capacitor 30, and so again provides a useful degree of protection to the switching elements 26A, 26B, 26C, 26D within the second switching module 124.

Further protection arrangements 600; 700 according to sixth and seventh embodiments of the invention are illustrated schematically, in combination with a second switching device 122, i.e. a full bridge module 132, in Figure 9.

Each of the sixth and seventh protection arrangements 600; 700 is similar to the aforementioned protection arrangements 10; 100; 200; 300; 400 and like features share the same reference numerals.

The sixth and seventh protection arrangements 600; 700 differ however in the manner in which the respective thyristor 12 therein is, in use, connected with the full bridge module 132. The main current-carrying terminals 14, 16 of each thyristor 12 are again connected in reverse parallel with the full bridge module 132, i.e. the second switching device 122 to be protected, but while the thyristor 12 in the sixth protection arrangement 600 has its cathode terminal 14 connected to the first main current-carrying terminal 18 of the full bridge module 132, its anode terminal 16 is instead connected to a first intermediate terminal 602 lying between the second switching element 26B and the primary capacitor 30. Similarly the thyristor 12 in the seventh protection arrangement 700 again has its cathode terminal 14 connected to the second main current-carrying terminal 20 of the full bridge module 132 but its anode terminal 16 is instead connected to a second intermediate terminal 702 lying between the fourth switching element 26D and the primary capacitor 30.

Each of the sixth and seventh protection arrangements 600; 700 again includes a trigger circuit 38 which is operatively connected with the gate control terminal 40 of the corresponding thyristor 12, and which is configured to apply a voltage to the gate control terminal 40 of the said corresponding thyristor 12 when the reverse voltage applied to the corresponding thyristor 12, i.e. the voltage across the primary capacitor 30 in the full bridge module 132, reaches the safety threshold voltage V₂.

Each trigger circuit 38 includes an auxiliary capacitor 44 (although other forms of energy storage device may be used) which is, in use, connected in parallel with the primary capacitor 30 via first and second series-connected resistive elements 46, 48.

Each trigger circuit 38 also includes a first passive current check element 52 in the form of a first breakover diode 58 and a second passive current check element 60 in the form of a second breakover diode 64, both of which are electrically connected in the same manner as in the first protection arrangement 10 shown schematically in Figure 1 (although the variants shown in Figures 2 and 3 may instead be adopted in still further embodiments of the sixth and seventh protection arrangements 600; 700).

In use each of the sixth and seventh protection arrangements 600; 700 works in essentially the same manner as the said first protection arrangement 10.

## Claims

1. A protection arrangement (10; 100; 200; 300; 400; 600; 700) for a switching device (22; 122), comprising:
a thyristor (12) having main current-carrying terminals which in use are connected in reverse parallel with a switching device (22; 122) to be protected, whereby during normal operation of the switching device (22; 122) a reverse voltage is applied to the thyristor (12); and
a trigger circuit (38) operatively connected with a gate control terminal (40) of the thyristor (12), the trigger circuit (38) being configured to apply a voltage to the gate control terminal (40) of the thyristor (12) when the reverse voltage applied to the thyristor (12) reaches a safety threshold voltage (V₂) whereby the thyristor (12) fails and presents an irreversible short-circuit across the main current-carrying terminals of the switching device (22; 122).

2. A protection arrangement (10; 100; 200; 300; 400; 600; 700) according to Claim 1 wherein:
the switching device (22) takes the form of a switching module (24; 124) for a voltage source converter, such a switching module (24; 124) including a plurality of switching elements (26A, 26B, 26C, 26D) connected in parallel with a primary energy storage device (28) and being selectively operable to provide a voltage source;
the trigger circuit (38) includes an auxiliary energy storage device (42); and
the trigger circuit (38) is configured in use to selectively connect the auxiliary energy storage device (42) in parallel with the primary energy storage device (28) during normal operation of the switching device (22; 122), and to selectively connect the auxiliary energy storage device (42) in series with the primary energy storage device (28) and the gate control terminal (40) of the thyristor (12) when the reverse voltage applied to the thyristor (12) reaches the safety threshold voltage (V₂).

3. A protection arrangement (10; 100; 200; 300; 400; 600; 700) according to Claim 2 wherein the trigger circuit (38) includes a first passive current check element (52) selectively operable in respective current blocking and current conducting states, the first passive current check element (52) in use being electrically connected in series between a positive terminal (54) of the primary energy storage device (28) and a negative terminal (56) of the auxiliary energy storage device (28).

4. A protection arrangement (10; 100; 200; 300; 400; 600; 700) according to Claim 3 wherein the first passive current check element (52) operates in its current blocking state when the voltage across it is less than a first trigger voltage, and operates in its current conducting state when the voltage across it is greater than or equal to the first trigger voltage.

5. A protection arrangement (10; 100; 200; 300; 400; 600; 700) according to Claim 4 wherein the first trigger voltage is selected to equal the safety threshold voltage (V₂).

6. A protection arrangement (10; 100; 200; 300; 400; 600; 700) according to any of Claims 2 to 5 wherein the trigger circuit (38) includes a second passive current check element (60) selectively operable in respective current blocking and current conducting states, the second passive current check element (60) in use being electrically connected in series between a positive terminal (62) of the auxiliary energy storage device (42) and the gate control terminal (40) of the thyristor (12).

7. A protection arrangement (10; 100; 200; 300; 400; 600; 700) according to Claim 6 wherein the second passive current check element (60) operates in its current blocking state when the voltage across it is less than a second trigger voltage, and operates in its current conducting state when the voltage across it is greater than or equal to the second trigger voltage.

8. A protection arrangement (10; 100; 200; 300; 400; 600; 700) according to Claim 7 wherein the second trigger voltage is less than or equal to the first trigger voltage.

9. A protection arrangement (10; 100; 200; 300; 400; 600; 700) according to any of Claims 2 to 8 wherein at least one passive current check element (52, 60) is one of:
a breakover diode (58, 64); and
a spark gap.

10. A protection arrangement (10; 100; 200; 300; 400; 600; 700) according to any of Claims 2 to 9 wherein the auxiliary energy storage device (42) is in use connected in parallel with the primary energy storage device (28) via at least one series-connected resistive element (46, 48).

11. A switching module (24; 124) for a voltage source converter including at least one protection arrangement (10; 100; 200; 300; 400; 600; 700) according to any preceding claim.
